# FASCICULE DE BREVET EUROPEEN

(11) **EP 3 157 057 B1**
(45) Date de publication et mention de la délivrance du brevet: **05.06.2019**
(21) Numéro de dépôt: 16193588.7
(22) Date de dépôt: 12.10.2016
(51) Int. Cl.: H01L 25/065, H01L 23/48, H01L 23/00, H01M 2/02, H01M 10/04, H01M 10/0525, H01M 10/0562, H05K 5/02

(54) **BOITIER POUR COMPOSANTS MICROÉLECTRONIQUES**
GEHÄUSE FÜR MIKROELEKTRONISCHE BAUTEILE
UNIT FOR MICROELECTRONIC COMPONENTS

(30) Priorité: 13.10.2015 FR 1559716
(43) Date de publication de la demande: 19.04.2017
(73) Titulaire: COMMISSARIAT À L'ÉNERGIE ATOMIQUE ET AUX ÉNERGIES ALTERNATIVES, 75015 Paris (FR)
(72) Inventeur: BEDJAOUI, Messaoud, 38340 VOREPPE (FR); SALOT, Raphaël, 38250 LANS-EN-VERCORS (FR)
(74) Mandataire: Decobert, Jean-Pascal

(56) Documents cités:
- EP-A1- 2 421 037
- EP-A1- 2 926 865
- WO-A1-2012/057853
- JP-A- 2001 127 241
- JP-A- 2009 105 326
- US-A1- 2003 107 119
- US-A1- 2003 232 460
- US-A1- 2008 094 793
- US-A1- 2015 084 157

## Description

### DOMAINE TECHNIQUE DE L'INVENTION

L'invention concerne un système électrique et un procédé pour sa fabrication. L'invention s'applique notamment au conditionnement de dispositifs microélectroniques sensibles à l'air et leur assemblage tridimensionnel (3D) permettant l'obtention de modules ou boitiers étanches à forte densité d'intégration.

L'invention trouve une application particulière dans l'assemblage de micro-batteries individuelles dans le but de réaliser des solutions d'alimentation à forte densité d'énergie.

### ÉTAT DE LA TECHNIQUE

L'assemblage des puces et dispositifs électroniques divers produits par l'industrie de la micro-électronique s'avère d'autant plus difficile que les couches actives des composants électroniques assemblés sont sensibles à l'air et à leur environnement en général. C'est le rôle du boitier que de permettre, d'une part, un assemblage des puces individuelles qu'il doit contenir avec la densité d'intégration souhaitée et leur interconnexion tout en garantissant, d'autre part, un fonctionnement pérenne du dispositif ainsi produit par une bonne étanchéité vis-à-vis des espèces oxydantes susceptibles d'altérer à terme le fonctionnement des puces. Concrètement, les niveaux d'étanchéité requis s'expriment en WVTR et OTR, acronymes de l'anglais « water vapor transmission rate » et « oxygen transmission rate » c'est-à-dire, respectivement, « taux de transmission de la vapeur d'eau » et « taux de transmission de l'oxygène ». Selon le degré de sensibilité des couches actives des composants électroniques assemblés, les valeurs admises pour ces paramètres peuvent varier entre 10⁻³ et 10⁻⁶ cm³.m⁻².j⁻¹.

Par ailleurs, la réalisation des interconnexions internes, entre puces d'une part, et avec les broches externes du boitier d'autre part, fait appel à de nombreuses techniques comme, entre autres, la brasure, la thermocompression et l'utilisation de colles époxydes chargées ou non d'argent. Un inconvénient de ces techniques est qu'il faut alors recourir pour leur mise en oeuvre lors de l'assemblage des puces à des étapes de recuit s'effectuant à des températures souvent élevées typiquement comprises dans une gamme allant de 250°C jusqu'à 1100°C ce qui impose de sévères contraintes aux puces durant la phase d'assemblage.

Par exemple, la demande de brevet internationale publiée sous le numéro WO94/28581 décrit une méthode d'assemblage de composants typique de l'art antérieur dans laquelle on crée une cavité en atmosphère contrôlée et où l'on obtient effectivement un boitier qui garantit une étanchéité de bonne qualité au regard des niveaux exigés pour l'ensemble des applications sensibles à l'air. Cependant, la réalisation des interconnexions décrite dans cet exemple nécessite de faire appel à des étapes technologiques mettant en oeuvre des températures élevées et notamment à la brasure de matériaux fusibles déjà mentionnée ci-dessus. La température de fusion de ces matériaux peut alors s'avérer être sensiblement plus élevée que la température maximale de fonctionnement de nombreux composants récents qu'il serait souhaitable de pouvoir assembler sans dommage. Parmi ces composants figurent ceux permettant un stockage d'énergie comme les micro-batteries au lithium ou encore tous les composants de l'électronique organique notamment les diodes électroluminescente organiques ou OLED acronyme de l'anglais « organic light-emitting diodes », les cellules photovoltaïques organiques ou OPV acronyme de l'anglais « organic photo voltaic cells »; les photo-détecteurs organiques ou OPD acronyme de l'anglais « organic photo detectors » ainsi que les transistors en couches minces dits TFT acronyme de l'anglais « thin film transistor ». A titre d'exemple, la température maximale de fonctionnement d'une batterie solide en lithium métal est fixée par la température de fusion de ce matériau qui est seulement de 180°C. Les dispositifs organiques sont encore plus contraignants qui supportent des températures qui ne peuvent pas dépasser des valeurs de l'ordre de 100°C.

Le document EP2421037 décrit une structure de montage de dispositif électronique qui comprend un élément de support comprenant des parties en saillie. Le dispositif électronique est fixé de sorte que les parties en saillie de l'élément de support soient insérées dans des trous traversants et le dispositif électronique est connecté électriquement aux parties en saillie.

Le document US2008/0094793 décrit des modules de substrat empilés qui sont insérés dans un boitier.

La présente invention permet de remédier au moins en partie aux inconvénients des techniques actuelles. Un objet potentiel de l'invention est de produire un système électronique étanche renfermant au moins un composant électronique de manière améliorée, notamment en termes de raccordement électrique au travers du boitier.

### RÉSUMÉ DE L'INVENTION

Un aspect de l'invention concerne un système électronique comprenant au moins un dispositif comprenant un substrat portant au moins un composant électronique doté d'au moins un connecteur électrique, le système comprenant en outre un support dudit dispositif.

De manière avantageuse, ce système est tel que le dispositif comprend au moins un passage suivant une dimension en épaisseur du dispositif, ledit au moins un passage traversant au moins le connecteur électrique, et il comprend au moins un pilier électriquement conducteur en saillie sur une première face du support, le pilier électriquement conducteur traversant le passage en étant configuré pour être en continuité électrique avec le connecteur électrique traversé par ledit passage.

Un autre aspect de l'invention est relatif à un procédé de fabrication d'un système électrique comprenant au moins un dispositif comprenant un substrat portant au moins un composant électronique doté d'au moins un connecteur électrique, le système comprenant en outre un support dudit dispositif, caractérisé en ce qu'il comprend :
- la formation dans le dispositif d'au moins un passage suivant une dimension en épaisseur du dispositif, ledit passage traversant au moins le connecteur électrique;
- la formation d'au moins un pilier électriquement conducteur en saillie sur une première face du support ;
- le montage du dispositif sur le support de sorte que chaque pilier électriquement conducteur traverse un passage en étant configuré pour être en continuité électrique avec le connecteur électrique traversé par ledit passage.

Ainsi, le pilier produit le raccordement électrique du composant porté par le dispositif suivant la hauteur du système ; ce raccordement comprend une phase de montage mécanique du dispositif, en insertion, autour du ou des piliers si bien que le raccordement est facilité et peut être produit à faible température.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 illustre l'obtention des éléments à assembler dans un boitier selon l'invention c'est-à-dire des micro-batteries selon un exemple de mise en oeuvre de celle-ci.
La FIGURE 2 est une vue en coupe d'une micro-batterie à assembler selon la ligne pointillé de la figure 1.
La FIGURE 3 illustre la réalisation des passages de vias traversants dans une micro-batterie destinée à être assemblée dans un boitier selon l'invention.
La FIGURE 4 est une vue coupe, suivant la ligne pointillée de la figure 5, d'une cavité, comprenant au moins deux piliers, destinée à accueillir les éléments à assembler pour former, après fermeture à l'aide d'un capot, un boitier étanche selon l'invention.
La FIGURE 5 est une vue en plan de de la cavité ci-dessus avec ses piliers de positionnement et d'interconnexion des éléments à assembler.
La FIGURE 6 illustre un exemple d'interconnexion parallèle de quatre micro-batteries dans une cavité.
La FIGURE 7 illustre l'étape de remplissage de la cavité à l'aide d'une résine isolante.
La FIGURE 8 illustre l'étape de fermeture de la cavité afin de former un boitier étanche selon l'invention.
La FIGURE 9 illustre le cas d'une cavité comportant plus de deux piliers.
La FIGURE 10 illustre la fermeture d'une cavité à l'aide d'une micro-batterie placée tête-bêche.
La FIGURE 11 illustre les étapes de réalisation d'une cavité et de piliers à partir d'un substrat en silicium.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et substrats peuvent ne pas être représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées suivant toute association ou alternativement :
- le pilier électriquement conducteur traverse le support de sorte à être exposé au niveau d'une deuxième face du support opposée à la première face. Ainsi, le pilier autorise l'accès électrique par l'extérieur du système.
- le composant électronique comprend deux connecteurs électriques chacun traversé par un passage, le système comprenant deux piliers électriquement conducteurs chacun en continuité électrique avec un, différent, des deux connecteurs électriques au travers du passage dudit un des deux connecteurs.
- le dispositif est de section rectangulaire suivant un plan perpendiculaire à la dimension en épaisseur et les deux piliers électriquement conducteurs sont dirigés suivant une diagonale de ladite section. La section rectangulaire s'entend comme incluant une section carrée. D'autres formes sont possibles dont une forme circulaire, polygonale, ovale...
- Le système comprend plusieurs dispositifs en superposition suivant la dimension en épaisseur, chacun avec un passage traversé par le au moins un pilier électriquement conducteur.
- le au moins un pilier électriquement conducteur comprend une interface de contact configurée pour assurer une continuité électrique entre une partie de tronc du pilier et le connecteur électrique.
- l'interface de contact est une résine ou une couche métallique électriquement conductrice, qui recouvre de préférence l'ensemble du tronc du pilier ; la couche métallique peut être déposée par une technique conventionnelle avec ou sans masque.
- Le système comprend un boitier définissant une cavité de réception du au moins un dispositif, le support formant un fond du boitier, le boitier comprenant une paroi latérale s'étendant à partir du support suivant la dimension en épaisseur. Une cavité reçoit ainsi les dispositifs, de sorte à les packager.
- la paroi latérale et le support sont monobloc. En ce sens, ils peuvent être formés d'une seule pièce de matière d'un même matériau. Ils peuvent néanmoins aussi être faits de pièces initialement distinctes et solidarisées ;
- un capot ferme la cavité et prend appui sur la paroi latérale.
- le capot comprend, pour chaque pilier électriquement conducteur, un passage suivant une dimension en épaisseur du capot de sorte à exposer le pilier sur une face du capot orienté à l'extérieur du boitier.
- le capot porte au moins un composant électronique doté d'au moins un connecteur électrique traversé par un passage du capot, un des au moins un pilier électriquement conducteur traversant le passage en étant configuré pour être en continuité électrique avec le connecteur électrique traversé par ledit passage.
- au moins un composant électronique porté par le capot est situé sur une face du capot orientée vers l'intérieur de la cavité et est de préférence relié au pilier.
- la cavité comprend un matériau de remplissage électriquement isolant autour du au moins un dispositif.
- le pilier électriquement conducteur est électriquement isolé du support.
- le au moins un composant électrique est une batterie.
- au moins un pilier additionnel est en saillie sur la première face du support, chaque pilier additionnel traversant un passage formé dans le dispositif suivant la dimension en épaisseur, le pilier additionnel étant configuré pour ne pas être en continuité électrique avec un connecteur électrique du composant électronique.
- la formation d'au moins un pilier électriquement conducteur est configurée de sorte qu'il traverse le support pour être exposé au niveau d'une deuxième face du support opposée à la première face.
- Le procédé comprend la formation d'un boitier définissant une cavité de réception du au moins un dispositif, le support formant un fond du boitier, le boitier comprenant une paroi latérale s'étendant à partir du support suivant la dimension en épaisseur.
- la paroi latérale et le fond sont obtenus par formation de la cavité dans un substrat de départ.
- Le procédé comprend la formation d'au moins un pilier électriquement conducteur comprend la formation d'un motif en creux de tronc de pilier dans le substrat de départ et le remplissage du motif par un matériau électriquement conducteur.
- Le procédé comprend la formation du boitier comprend, après la formation du au moins un pilier électriquement conducteur, une gravure d'une portion du substrat de départ configurée pour laisser en place le au moins un pilier, le fond et la paroi latérale du boitier.
- la formation d'au moins un pilier électriquement conducteur comprend la formation d'une partie de tronc de pilier en saillie sur le support et dans lequel la formation d'au moins un passage et la formation d'au moins un pilier électriquement conducteur sont configurées pour préserver un espace entre le tronc de pilier et le passage, le procédé comprenant une étape de formation d'une interface de contact entre le tronc de pilier et le passage, par remplissage au moins de l'espace avec une résine conductrice.

Il est précisé que, dans le cadre de la présente invention, le terme «sur» ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément. Le capot placé sur le support n'implique donc pas nécessairement un contact entre ces deux éléments ; au contraire, un espace est préférentiellement préservé, en formant une cavité.

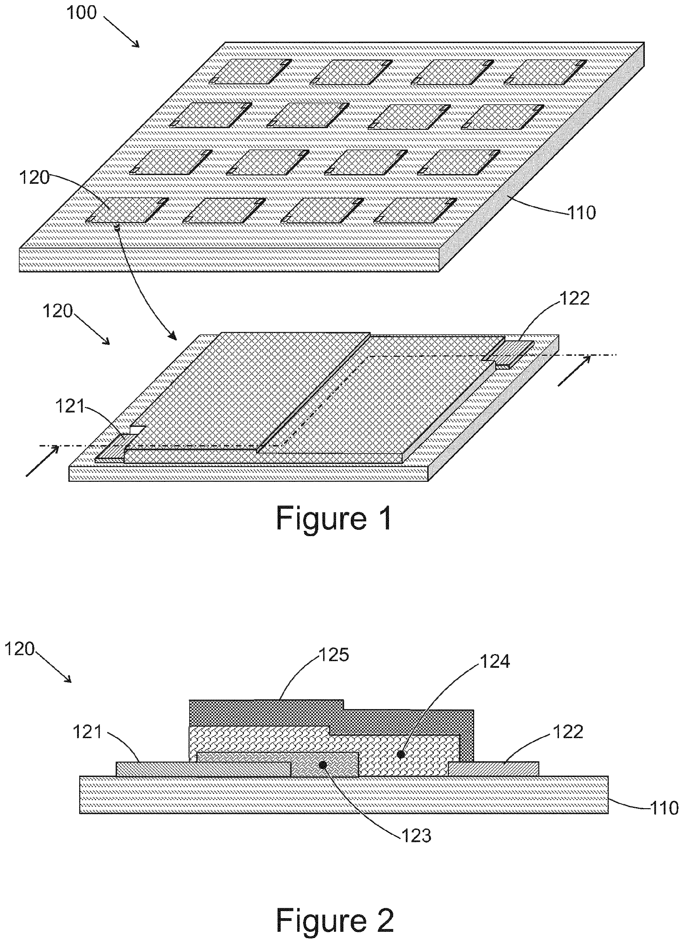

Il est précisé que dans le cadre de la présente invention, l'épaisseur d'une couche se mesure selon une direction perpendiculaire à la surface selon laquelle cette couche présente son extension maximale. Sur la figure 2 par exemple, l'épaisseur est prise selon la verticale.

L'invention concerne notamment un procédé de réalisation d'un système électrique, de préférence un dispositif microélectronique. Selon l'invention, on entend par dispositif microélectronique, un dispositif comportant des éléments de dimensions microniques et/ou nanométriques. Il en va de même du terme « composant électronique ». Tout système ayant pour son fonctionnement au moins un élément électrique entre dans le cadre de l'invention. Le système de l'invention peut renfermer des composants de natures différentes.

Le procédé qui suit a pour but préférentiel de réaliser un dispositif (micro)électronique en référence aux figures. On entend préférentiellement par substrat, une puce ou une plaque (plus communément dénommée « wafer », en anglais) comprenant au moins une puce.

Le domaine d'application de la présente invention couvre potentiellement toute la gamme des dispositifs produits par l'industrie de la micro-électronique et intéresse plus particulièrement ceux des dispositifs qui sont confrontés aux contraintes liées à la sensibilité de leurs couches actives aux éléments oxydants contenus dans leur environnement notamment la vapeur d'eau et l'oxygène de l'air ambiant. Le domaine d'application s'étend à tout système électronique sophistiqué réalisant des fonctionnalités complexes obtenues généralement en associant plusieurs composants électroniques individuels. Sans perte de généralité, l'invention est plus particulièrement décrite ci-après à l'aide d'un exemple où l'on procède à l'assemblage dans un boitier de micro-batteries solides en lithium métal réalisées préalablement en couches minces (TFT) sur des substrats ultrafins d'une épaisseur inférieure à 100 µm (µm ou micromètre = 10⁻⁶ mètre).

Les étapes de cet exemple spécifique d'un assemblage selon l'invention de micro-batteries au lithium sont résumées de façon détaillée ci-après.

C'est notamment un objet de l'invention que de décrire un procédé ne nécessitant pas forcément la mise en oeuvre d'opérations s'effectuant à des températures élevées, pour ne pas endommager les composants assemblés. C'est aussi un objet potentiel de l'invention que de décrire un procédé permettant d'obtenir un boitier ou module suffisamment étanche qui assure un fonctionnement pérenne du dispositif assemblé en préservant les puces qui le composent d'une dégradation due aux gaz oxydants de l'atmosphère c'est-à-dire vapeur d'eau et oxygène.

Dans un mode de réalisation préféré correspondant aux figures, le système de l'invention comporte une pluralité de dispositifs chacun portant au moins un composant électronique. Il est entendu que l'invention peut ne comporter qu'un seul de ces dispositifs.

La figure 1 illustre le résultat d'une première étape au cours de laquelle les composants électroniques portés par les dispositifs à assembler, c'est-à-dire ici des ensembles de micro-batteries dans cet exemple de mise en oeuvre de l'invention, sont produits. Selon un mode de réalisation, un ensemble 100 de batteries individuelles 120 est disposé simultanément sur un substrat 110 formant un substrat hôte, par exemple en verre, au cours d'une même série d'étapes de fabrication. Typiquement, le verre utilisé appartient à la famille des borosilicates. Un verre de cette famille couramment utilisé est connu sous la référence « AF32 ». L'épaisseur du substrat hôte qui constitue la base du dispositif est typiquement de 50 µm. Il peut accueillir un ensemble de plusieurs micro-batteries disposées par exemple, comme montré sur la figure 1, de façon matricielle ou seulement une seule micro-batterie.

La figure 2 est une vue schématisée en coupe d'une batterie individuelle 120. Elle montre l'empilement des couches constituant une batterie individuelle et notamment ses connecteurs 121 et 122 qui sont ici des collecteurs de courant, le tout reposant sur le substrat 110. L'association du substrat 110 et d'au moins un composant électronique tel une batterie 120 forme un dispositif de l'invention, rapportable sur un support de boitier décrit plus loin.

Un des connecteurs est dit cathodique et l'autre anodique. Ce sont les connecteurs 121 et 122 qui jouent ces rôles. Ils sont tous deux conducteurs et de préférence de nature métallique et faits par exemple de titane, d'or, d'aluminium, de platine, de tungstène et plus généralement constitués de tout autre métal ou alliage de métaux ayant une bonne conductivité électrique. D'une épaisseur typique de 0,5 µm les connecteurs sont disposés directement sur le substrat 110. Chaque connecteur 121, 122 assure une possibilité de reprise de contact pour une électrode 123, 125. Ces électrodes 123, 125 encadrent une couche intercalaire électriquement isolante formant un électrolyte 124.

Les couches actives de la micro-batterie susceptibles d'être sensibles à l'air ambiant et à l'environnement sont essentiellement les deux électrodes 123 et 125 et l'électrolyte 124. L'électrode positive 123, d'une épaisseur typique de 5 µm, est avantageusement faite d'un matériau ayant une bonne conductivité électronique et ionique comme par exemple les matériaux suivants : TiOS, TiS₂, LiTiOS, LiTiS₂, LiCoO₂ et V₂O₅. L'électrolyte 124, d'une épaisseur typique de 2 µm, est un isolant électronique avec une forte conductivité ionique. Le LiPON est l'électrolyte le plus employé dans la technologie des micro-batteries mais on a aussi recours à d'autres matériaux comme le LiPONB et le LiSiCON. L'électrode négative 125 est une couche d'une épaisseur typique de 2 µm qui peut être constituée exclusivement de lithium métallique, on obtient alors une batterie dite « lithium métal ». L'électrode négative peut aussi être faite d'un matériau dit « lithié », c'est-à-dire incorporant du lithium, on obtient alors une batterie dite « lithium ion ». Les batteries en lithium métal sont extrêmement sensibles aux espèces oxydantes. Elles requièrent un niveau d'étanchéité du boitier plus élevé que celles dites « lithium ion ».

Le composant électronique peut par exemple avoir un contour extérieur à bords rectilignes. De préférence, l'empilement de couches comprend, au niveau de chaque connecteur 121, 122, un décrochement, par exemple un coin en retrait formant un angle de 90°, de sorte à définir une zone du composant où seul le connecteur 121, 122 est exposé. Cette zone exposée de chaque connecteur 121, 122 peut prendre toute forme et tout emplacement adapté à l'application souhaitée. De préférence, cette zone est en périphérie du reste du composant électronique. Dans un cas non illustré, au moins un des connecteurs ne repose pas, ou pas entièrement, sur le substrat 110 ; il peut par exemple être déporté latéralement relativement à une bordure du substrat 110 ou encore être en élévation relativement à la face du substrat 110. Ainsi, la partie du connecteur coopérant avec le pilier (qui sera décrit en détail plus loin) n'est pas forcément au contact du substrat 110. Dans ce cas de figure, il n'est pas nécessaire que le passage (qui sera décrit en détail plus loin) traverse aussi le substrat.

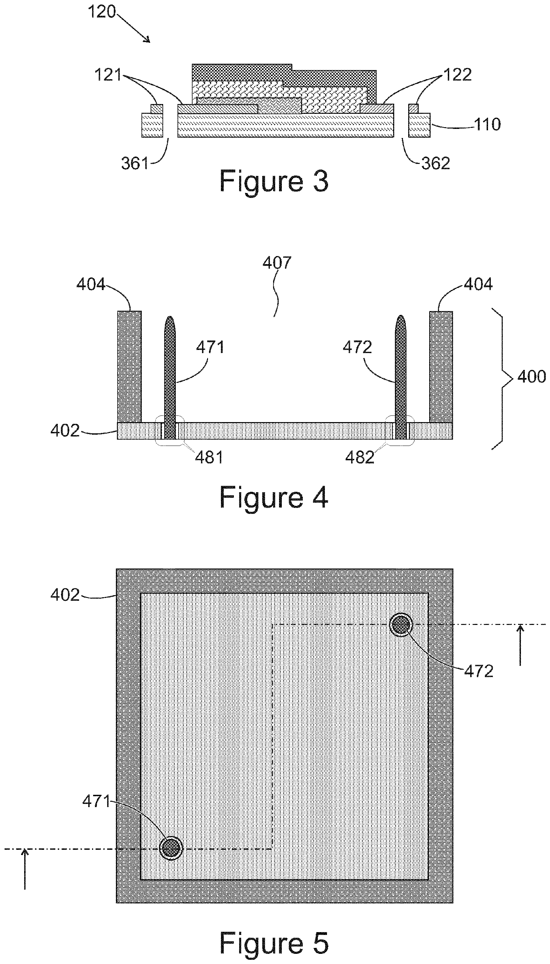

A l'étape suivante on procède à la réalisation de passages de vias traversants et, si elles étaient portées par un même substrat hôte, à la séparation des micro-batteries pour permettre leur assemblage 3D dans un boitier de l'invention. Selon un mode préféré de mise en oeuvre de l'invention illustré par la figure 3, on réalise des passages de vias traversants sur chacune des batteries individuelles après avoir formé celles-ci comme décrit dans la figure 2 et obtenu l'empilement de couches correspondant. Les passages 361 et 362, sont positionnés à l'intérieur de la surface de préférence plane définie par les zones exposées des deux connecteurs de courant 121 et 122. On crée ainsi deux passages, par exemple de forme circulaire et d'un diamètre de 500 µm, qui traversent complètement les couches superposées constituées par les connecteurs de courant 121 et 122 et le substrat en verre 110. Les passages de vias traversants sont obtenus après avoir procédé à des opérations classiques d'ablation laser connues de l'homme du métier et pratiquées de façon conventionnelle à l'aide, par exemple, d'un laser à excimère employant une source d'une longueur d'onde de 248 nm ou d'un laser dit YAG, acronyme faisant référence à l'utilisation comme amplificateur d'un grenat d'yttrium-aluminium dopé, d'une longueur d'onde de 355nm. La section des passages peut être choisie de forme quelconque. Des formes géométriques simples : carré, rectangle, cercle ou ovale, sont de préférence retenues. Dans un premier cas, la forme choisie correspond à la section des troncs de piliers d'un boitier selon l'invention comme décrit ci-après. Cela permet un contact direct entre la paroi du passage (et surtout avec de pourtour du connecteur correspondant) et le pilier. Dans un autre cas, un jeu peut subsister sous forme d'un espace entre passage et tronc de pilier, et il est fait emploi d'une interface conductrice, de préférence sous forme de résine conductrice, comme décrit plus loin.

Optionnellement, les passages 361 et 362, d'une même batterie individuelle peuvent être de formes différentes. Optionnellement, les ouvertures des passages de vias traversants peuvent être réalisées après dépôt et formation des zones collectrices de courant réalisées par les connecteurs 121 et 122, et avant création des couches actives de la micro-batterie 123, 124 et 125.

Après création des passages 361, 362 sur la micro-batterie 120 d'un ensemble 100 de micro-batteries partant d'un même substrat hôte, on procède à leur séparation par découpage du substrat hôte 110 en ayant recours, par exemple, à un sciage mécanique, technique qui est couramment pratiquée par toute l'industrie de la microélectronique pour la séparation des puces. Dans le cas d'un substrat en verre fin comme dans l'invention, on peut aussi recourir à une autre technique de découpe laser qui est de pratique courante également. Différents types de laser peuvent être employés à cette fin : laser au dioxyde de carbone (CO2), laser YAG ou à excimère mentionnés ci-dessus et laser femtoseconde.

La figure 3 montre donc l'empilement des couches formées sur le substrat 110 et constituant une batterie 120 caractérisée, en ce qui concerne l'invention, par ses connecteurs de courant, 121 et 122, et ses passages de vias traversants, 361 et 362. Dans cet exemple, la surface totale occupée par une batterie individuelle après découpage est typiquement un carré de 1 centimètre de côté d'une épaisseur totale qui est environ de 9,5 µm. Les surfaces occupées par les zones exposées collectrices de courant, 121 et 122, sont identiques et occupent chacune un carré de l'ordre de 1 millimètre de côté. Ces valeurs sont données à titre d'exemple et ne sont pas limitatives de l'invention. On notera que les passages 361, 362 peuvent avoir des formes et dimensions différentes les uns des autres. En outre, il peut s'agir de vias au contour fermé mais aussi de passage interférant avec la tranche du support si bien que de tels passages ont une paroi latérale non fermée, par exemple avec une section en demi-cercle ou en U. Toute disposition traversant le support entre dans le cadre de l'invention.

Les dispositifs à batterie(s) individuelle(s) 120 obtenues à l'issue des étapes précédentes sont ensuite empilées les uns sur les autres dans une cavité d'accueil ouverte 407 illustrée sur la figure 4. Celle-ci est destinée à former in fine le boitier étanche 400 contenant l'assemblage 3D de micro-batteries portées par des dispositifs superposés. A ce stade la cavité est définie par un support formant le fond 402 de la cavité et des parois latérales 404, ces parois 404 étant avantageusement solidaires du fond 402. La cavité est caractérisée par la présence d'au moins un pilier électriquement conducteur et de préférence d'au moins deux piliers, 471 et 472, parallèles aux parois et représentés verticalement sur cette figure. Les dimensions internes de la cavité ouverte sont avantageusement à minima identiques aux dimensions hors-tout d'une batterie individuelle après découpage comme illustré sur la figure 3. Les piliers, réalisés par exemple en métal ou dans un alliage de métaux, sont implantés au niveau du support formant le fond de la cavité 402 en permettant de préférence d'obtenir une isolation électrique entre la cavité et les piliers métalliques, par exemple en isolant électriquement les piliers électriquement conducteurs relativement au fond 402 par un remplissage à leur interface qui est de nature isolante ; cela est en particulier souhaité dans le cas d'un fond 402 conducteur. Alternativement ou en complément, l'assemblage pilier/fond permet de garantir l'étanchéité demandée par l'application vis-à-vis de l'atmosphère extérieure. La réalisation de traversées isolantes et étanches est par exemple basée sur les techniques traditionnelles de fusion du verre comme le scellement verre-métal ou verre-céramique pour l'interface avec le pilier. Le verre utilisé de préférence a une composition ajustée afin d'assurer ses fonctions d'étanchéité et d'isolation au niveau requis par l'application. De plus, le coefficient d'expansion thermique (CTE) est adapté aux matériaux composant les piliers et la cavité pour ne pas développer de contraintes mécaniques qui seraient susceptibles de nuire à l'étanchéité du boitier et de provoquer des fuites.

La figure 4 est une représentation schématique illustrative d'une cavité ouverte selon l'invention. On donnera plus loin un mode de réalisation de sa fabrication. Dans un mode de réalisation préféré, un feuillard d'une épaisseur de l'ordre de 1 mm (millimètre) en alliage Fe-Ni-Co, dans les proportions suivantes : 54 % Fe, 29 % Ni et 17 % Co, du type dit « Kovar » est utilisé pour la réalisation de la cavité ouverte 407 équipée de ses deux piliers verticaux, 471 et 472, avec des interfaces hermétiques (typiquement verre-métal) 481 et 482. Un des avantages liés à l'utilisation d'un feuillard fait d'un alliage de type « Kovar » mentionné ci-dessus réside dans ses propriétés thermiques. En effet, la valeur du coefficient d'expansion thermique de ce matériau est stable dans une large gamme de température allant de 25°C à 300°C. Elle est aussi très proche de celle d'un verre borosilicate employé pour les traversées hermétiques c'est-à-dire de l'ordre de 5x10⁻⁶ K⁻¹. La surface interne de la cavité ouverte 407 est, par exemple, un carré de 1,02 cm de côté, c'est-à-dire légèrement plus grand que les dimensions d'un dispositif obtenu après découpage, soit 1 cm de côté, valeur mentionnée précédemment à titre d'exemple dans la description de la figure 2. La hauteur des parois verticales 404 est par exemple de l'ordre 800 µm tandis que l'épaisseur du support formant le fond 402 de la cavité est de l'ordre de 200 µm. Les piliers, par exemple en métal ou alliage métallique, 471 et 472, ont, comme l'a déjà vu, une section d'une forme géométrique adaptée à celle des passages 361 et 362. Dans cet exemple, ils sont de forme cylindrique avec une section externe de 250 µm sur une hauteur totale de 1000 µm. La partie des piliers en alliage de type « Kovar » où viennent se loger les dispositifs portant les micro-batteries individuelles est alors d'une hauteur de 800 µm. Ces valeurs et dimensions sont données à titre d'exemple destiné à illustrer une mise en oeuvre de l'invention et ne sont pas limitatifs de cette dernière. D'autres valeurs et dimensions, possiblement très différentes, en fonction des applications considérées de l'invention sont possibles.

La figure 5 est une vue en plan d'un exemple de positionnement des piliers verticaux, 471 et 472, sur le support formant le fond 402 de la cavité. Ceux-ci sont positionnés de façon à correspondre aux passages 361 et 362 qui traversent les connecteurs de courant 121 et 122, et le substrat 110 de chaque batterie individuelle 120 comme illustré sur la figure 3. En fonction des applications et des dispositifs 120 qu'il faut pouvoir assembler la position occupée par les piliers peut être différente de celle illustrée sur la figure 5. Ici, le composant formé par la micro-batterie 120 est de section rectangulaire (en l'espèce carrée) suivant le plan du fond 402 et les piliers 471, 472 sont espacés suivant une diagonale de cette section.

A l'étape suivante on va procéder à un assemblage de plusieurs dispositifs dans un boitier selon l'invention en les empilant dans la cavité 407 décrite ci-dessus. L'un des aspects de la présente invention concerne notamment l'intégration tridimensionnelle de micro-batteries au lithium permettant d'obtenir une densité d'énergie par unité de surface plus grande. Il est par exemple possible d'obtenir un accumulateur lithium à partir d'opérations d'interconnexion en parallèle ou en série de plusieurs batteries individuelles. Pour une connexion en série, on peut notamment la produire par : inversion des contacts électriques lors de la réalisation des composants ; par une rotation d'un deuxième composant empilé sur le premier afin de faire correspondre le collecteur négatif avec le collecteur positif. Il est aussi possible d'envisager une combinaison de composants associés en série et de composants associés en parallèle, par exemple un empilement total de quatre batteries formé de 2 composants en parallèle en série avec 2 autres composants en parallèle

Avantageusement, on peut tirer parti d'un boitier selon l'invention pour empiler des dispositifs microélectroniques, sensibles à leur environnement, de natures différentes, afin d'obtenir des fonctionnalités plus complexes que celles fournies par un seul et même composant individuel. Par exemple, on peut réaliser des modules de récupération et de stockage d'énergie par assemblage de batteries lithium et de cellules photovoltaïques au sein d'un même boitier. Ces composants multiples peuvent être connectés entre-eux et/ou raccordés électriquement à l'extérieur du boitier au moyen de piliers conducteurs distincts.

Selon l'un des principes de cette invention, les piliers 471, 472 en permettent d'enfiler verticalement les dispositifs l'un sur l'autre.

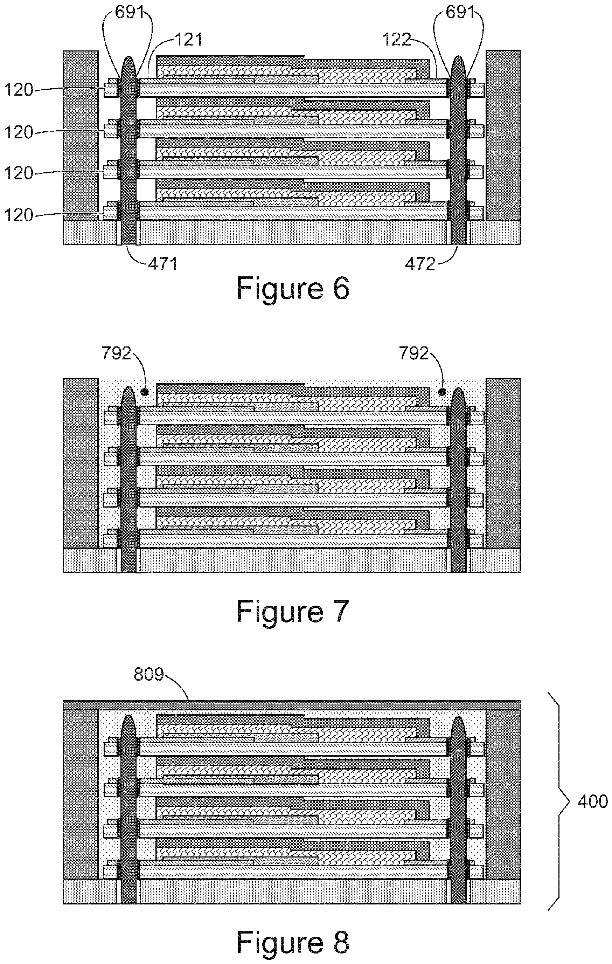

La figure 6 illustre une interconnexion parallèle de batteries individuelles 120 au nombre de quatre dans cet exemple. Elles sont enfilées sur les piliers, 471 et 472, au travers des passages traversants 361 et 362, ménagés comme on l'a vu précédemment dans chacune des micro-batteries. Dans ce type de montage on relie électriquement tous les connecteurs 121 correspondant à chaque batterie par l'intermédiaire du pilier 71 et tous les connecteurs 122 par l'intermédiaire du pilier 472. De façon identique, il est tout à fait envisageable de réaliser un montage série. On remarquera qu'un boitier selon l'invention confère un avantage important en permettant qu'un auto-alignement des éléments à assembler se fasse ainsi automatiquement sur les piliers 471 et 472. Dans le cas de la figure 6, les supports des dispositifs viennent au contact de l'électrode supérieure 125 du composant électronique du dispositif placé en-dessous et ces supports sont de préférence diélectriques à ce niveau.

La connexion électrique créée entre les deux piliers 471 et 472, et les connecteurs de courant 121 et 122, est, dans un mode de réalisation, renforcée ou assurée par le remplissage des espaces laissés libres en raison d'une éventuelle différence de section entre les piliers et les passages de vias, 361 et 362. Dans cette situation, le pilier comprend un tronc de pilier (qui est avantageusement une structure mécaniquement autoporteuse) et une interface (qui est avantageusement une partie de remplissage des espaces). Eventuellement, seuls certains piliers comportent ce remplissage. Dans l'exemple de la figure 6 on pourra avoir recours à un remplissage localisé de ces espaces en formant une interface conductrice 691 avec une résine conductrice, remplissage effectué après chaque étape de positionnement d'une batterie individuelle d'un niveau et avant empilement de la batterie du niveau supérieur suivant. Pour ce faire, on utilise notamment des résines à base de polymères conducteurs dites « E4110 » commercialisées par la société Epo-Tek qui permettent, après un traitement thermique à 150°C pendant une durée de 15 minutes, de consolider le contact électrique au niveau de chaque pilier. D'autres techniques sont possiblement utilisées pour le remplissage des espaces interstitiels comme le laminage d'un film conducteur ou l'électrodéposition de couches conductrices, ou encore un dépôt par pulvérisation de cibles métalliques.

La figure 7 illustre l'étape suivante de finalisation du boitier étanche au cours de laquelle on procède éventuellement au remplissage de la cavité ouverte contenant à ce stade les quatre batteries en parallèle de cet exemple. Le remplissage se fait par exemple à l'aide de résines non conductrices avant fermeture avec un capot étanche aux oxydants comme illustré dans la figure suivante. En premier lieu, la fixation mécanique des batteries est assurée par une opération de collage effectuée avec des colles isolantes comme les époxydes thermiques ou à l'aide de films adhésifs non conducteurs (non représentés). Après remplissage, comme le montre la figure 7, les batteries sont de ce fait noyées dans une résine de surmoulage 792 qui sert à la fois à protéger, à fixer et à consolider mécaniquement l'ensemble. Ce sont généralement des polymères composites à base d'époxyde renforcés parfois par des charges minérales à base de silice ou d'alumine qui seront utilisés. La résine isolante recouvre de préférence entièrement les batteries en créant une surface plane qui facilite le report d'un capot de fermeture du boitier comme on le voit dans la figure suivante. Les piliers 471, 472 sont, dans cet exemple, de hauteur moindre que la cavité 407, de sorte à ne pas interférer avec le capot 809.

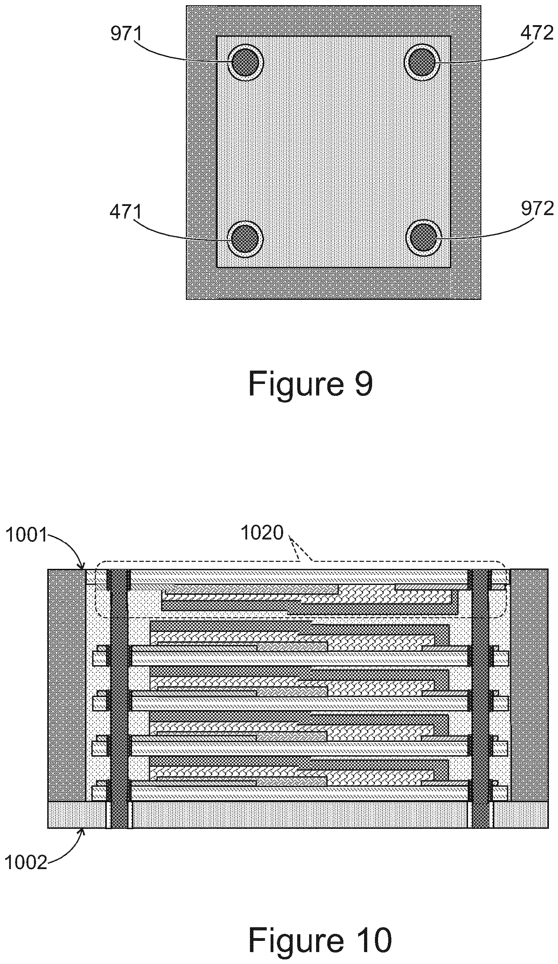

La figure 8 est une représentation schématique du boitier obtenu après avoir procédé au report d'un capot étanche 809 par des techniques classiques comme le laminage par adhésif, le collage direct en utilisant la résine de remplissage de la cavité ou le scellement par abrasion ou par soudure. Le capot est choisi de préférence dans la famille des matériaux faisant barrière à l'eau et ou à l'air avec des valeurs WVTR comprises entre 10⁻⁴ et 10⁻⁶ g.m⁻².j⁻¹ et OTR entre 10⁻⁴ et 10⁻⁶ cm⁻³.m⁻² j⁻¹. A titre d'exemple, le capot 809 est un simple film métallique en aluminium de 50 µm d'épaisseur collé directement en utilisant les propriétés de collage de la résine de remplissage 692. L'utilisation d'autres types de films mono ou multicouches pourvus d'adhésif est également possible pour la réalisation du capot. Le capot 809 peut aussi porter un ou plusieurs composants électroniques comme dans le cas de figure de la figure 10. Dans le cas de l'incorporation de composants tels que des cellules photovoltaïques, il sera utile de disposer d'un capot 809 et/ou d'un fond 402 transparents et que la ou les cellules soient en regard de ce capot et/ou du fond 402. Préférentiellement, il faut aussi envisager des parois transparentes et/ou des résines de remplissage transparentes dans ce cas.

Le boitier final 400 obtenu après avoir exécuté les différentes étapes détaillées ci-dessus est dimensionné pour recevoir des batteries individuelles identiques. Comme on l'a vu, elles sont dans cet exemple d'une surface carrée de l'ordre de 1 cm de côté et d'une épaisseur de 9,5 µm disposées sur un substrat de 50 µm d'épaisseur. Dans ces conditions, les dimensions finales du boitier sont celles d'un parallélépipède à base carrée de 1,1 cm de côté et d'une hauteur de 0,1 cm. Ceci n'est qu'un exemple, les dimensions de la cavité d'un boitier selon l'invention pouvant, comme on l'a vu, être adaptées pour accueillir des batteries individuelles et, plus généralement, tout dispositif électronique de tailles quelconques.

Selon une autre possibilité, les piliers 471 et 472 de la figure 6 peuvent être positionnés librement en périphérie du composant mais aussi à l'intérieur de la partie active de la micro-batterie. La seule condition est de faire correspondre géométriquement ces piliers avec les passages, 361 et 362, débouchant sur les connecteurs collecteurs de courant de chaque batterie unitaire. Dans ce cas, une zone à l'intérieur de la partie active de la micro-batterie présente au moins une partie des connecteurs électriques ; cette situation correspond à une configuration qui serait différente de celle des figures, car la répartition des connecteurs et des parties actives de batteries sont modifiées, pour dégager une zone de connexion au sein des couches actives.

Afin de rigidifier le système final et d'améliorer le maintien des dispositifs superposés au sein de la cavité 407, il est possible d'augmenter le nombre des piliers verticaux en en créant d'autres en périphérie de la surface active. Des passages correspondant sont formés de manière additionnelle au travers du ou des dispositifs. La figure 9 présente un exemple de réalisation avec quatre piliers positionnés au niveau des coins des batteries individuelles. Dans cet exemple on y retrouve les deux piliers précédents : 471 et 472, qui, respectivement, connectent les connecteurs: 121 et 122, de chaque batterie individuelle. D'un point de vue électrique, les piliers additionnels 971 et 972, peuvent être passifs ou actifs. Le rôle des piliers passifs est purement mécanique tandis que celui des actifs est double, électrique et mécanique. Bien que la batterie ne dispose que deux sorties électriques l'une anodique et l'autre cathodique, il est possible en effet d'avoir plusieurs piliers verticaux avec un routage permettant de connecter plusieurs piliers entre eux. Dans le cas de piliers actifs, ils peuvent avoir la même conception que les deux piliers électriquement conducteurs 471, 472. Si le ou les piliers additionnels sont passifs, ils peuvent être formés à partir d'un matériau diélectrique et/ou traverser un passage dans une zone diélectrique ou pour le moins non active du dispositif et/ou présenter un matériau diélectrique d'isolation entre le tronc de ces piliers et la zone du dispositif traversée.

Comme illustré sur la figure 10, le capot 809 peut autoriser une reprise de contact pour au moins un des piliers électriquement conducteurs 471, 472 au travers de son épaisseur. Des passages sont alors réalisés dans le capot 809, comme dans le cas du fond du support 110, de sorte à coopérer avec les piliers 471, 472. Cela autorise un double accès aux contacts électriques de la ou les micro-batteries 120 soit par la face supérieure 1001 soit par la face inférieure 1002 du boitier. Dans cette situation, les piliers électriquement conducteurs 471, 472 sont de préférence d'une hauteur suffisante pour traverser au moins une partie de l'épaisseur des passages du capot 809.

Un autre aspect alternatif ou combinable consiste à faire porter par le capot 809 un composant électronique. Il peut s'agir par exemple d'une batterie identique aux composants empilés. Pour satisfaire cette disposition, le capot muni d'une dernière batterie, formant un ensemble 1020, utilisé comme fermeture de la cavité ouverte est avantageusement montée en configuration tête-bêche. Avantageusement, cette variante permet d'augmenter la densité de puissance surfacique par rapport à la configuration principale.

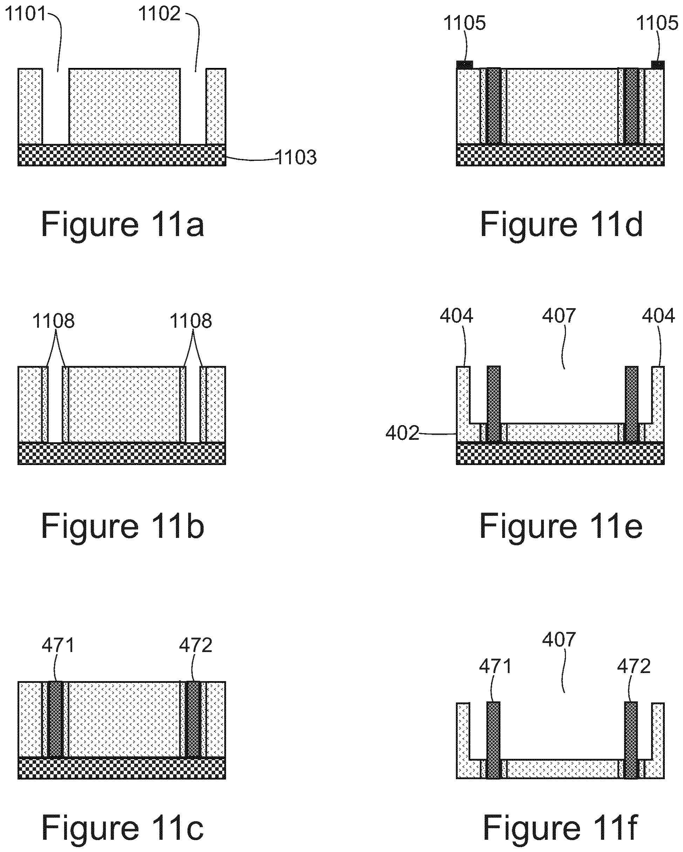

Les figures 11a à 11f décrivent un exemple de réalisation de la cavité 407 et des piliers 471, 472. La cavité ouverte est obtenue dans ce cas préférentiellement à partir d'un substrat en matériau étanche aux oxydants de l'air ambiant comme le silicium, la céramique ou le verre. La première étape illustrée par la figure 11a consiste à réaliser autant de trous que de piliers à former et dans l'exemple deux trous 1101 et 1102, dans le substrat choisi comme base de réalisation du support boitier. La forme, le diamètre externe et le positionnement géométrique des trous sont adaptés à ceux des passages de vias, 361 et 362, qui ont été réalisés dans chaque micro-batterie 120 comme illustré sur la figure 3. Leur section externe doit être inférieure ou égale à celle de ces passages de vias. Ils peuvent être obtenus en mettant en oeuvre les techniques de photo-lithogravure. Dans un mode de réalisation préféré, les trous 1101 et 1102, sont définis par photolithographie et gravure d'un substrat de silicium rendu solidaire de façon temporaire d'un support 1103, par exemple également fait de silicium, servant de poignée de manipulation. La gravure de ces trous, sur toute l'épaisseur du substrat en silicium, est réalisée par exemple en utilisant des gravures plasmas anisotropes à partir de gaz fluoré ou fluoré-carbonés Ainsi, par exemple, dans un substrat silicium d'une épaisseur de 1000 µm, on grave deux trous, 1101 et 1102, d'une section de 250 µm traversant toute l'épaisseur de ce substrat jusqu'à la poignée de manipulation 1103.

Pour la formation des piliers, on procède ensuite au remplissage des trous, à l'aide, dans le cas de piliers électriquement conducteurs, d'un matériau ayant une excellente conductivité électronique, c'est-à-dire supérieure à 10² S.m⁻¹. Le remplissage peut se faire selon plusieurs méthodes avec différents types de matériaux conducteurs : par exemple en utilisant des polymères conducteurs ou en pratiquent une métallisation à l'aide d'un dépôt électrolytique ou par pulvérisation. A titre d'exemple non limitatif, les matériaux de remplissage sont choisis conducteurs comme le tungstène, le cuivre ou en le silicium polycristallin. Selon un mode de réalisation préféré, le remplissage des trous est fait à l'aide d'une métallisation de cuivre obtenue par électrolyse. Avant l'étape d'électrolyse proprement dite, comme montré sur la figure 11b, au moins une couche isolante 1108 est déposée sur les parois internes des trous. Les matériaux utilisables pour cette couche comprennent : l'oxyde de silicium, le nitrure de silicium et, de préférence, l'oxynitrure de silicium (SiON) déposé sur une épaisseur de 2 µm à l'aide d'une technique de dépôt chimique en phase vapeur. Optionnellement, la couche isolante peut être renforcée par une couche barrière de TiN/Ti ou de TaN/Ta qui sert à empêcher toute diffusion du cuivre dans le matériau constituant le substrat 1100.

Le procédé d'électrolyse débute par le dépôt d'une couche primaire (non représentée) de cuivre au niveau des parois de chaque trou 1101 et 1102. La fonction principale d'une telle couche est de permettre l'amorçage du dépôt électrolytique de cuivre qui va suivre. Cette couche primaire est déposée sur une épaisseur typique de 10 µm. Elle peut être réalisée par électrolyse, mais de préférence par des techniques successives connues de dépôt physique en phase vapeur ou PVD, acronyme de l'anglais « physical vapor déposition » et de dépôt chimique en phase vapeur ou CVD, acronyme de l'anglais « chemical vapor déposition ». Cette couche primaire a pour fonction d'initier le dépôt électrolytique du cuivre ou autre matériau.

Comme illustré sur la figure 11c, le dépôt électrolytique des piliers 471, 472 est ensuite effectué en utilisant par exemple une large gamme d'électrolytes, aussi bien alcalins qu'acides. L'utilisation de bains acides à base de sulfates est préconisée pour la mise en oeuvre de l'invention. L'utilisation de chlorures ou de fluoborates est également possible.

L'étape suivante est illustrée par la figure 11d où l'on procède au dépôt d'une couche de résine ou d'oxyde de silicium dans laquelle on définit et réalise à l'aide de procédés de photo-lithogravure standard, un masque dur 1105.

Comme montré sur la figure 11e, le masque dur permet ensuite de définir les zones correspondantes aux parois 404, 1160 et fond 402 de la cavité ouverte 407 créée après gravure du substrat. Le procédé de gravure du silicium du substrat est potentiellement identique à celui décrit précédemment. La profondeur de silicium gravée est par exemple de l'ordre de 800 µm afin de laisser un fond 402 d'une épaisseur de 200 µm. A la fin de l'étape de gravure du silicium du substrat, l'oxyde d'isolation 1108 est finalement gravé également, au niveau des parties des piliers libérées par la gravure de la cavité 407, de préférence avec le même procédé que celui utilisé pour la gravure du masque dur 1105.

Comme montré sur la figure 11f, après séparation d'avec la poignée de manipulation par des moyens classiques, on obtient, comme précédemment, une cavité ouverte 407 équipée dans cet exemple de deux piliers métalliques verticaux 471, 472 isolés électriquement de la paroi 404, et du fond 402, par la couche isolante 1108. Les dimensions caractéristiques de la cavité sont, par exemple, identiques à celles obtenues précédemment, c'est-à-dire un carré de 1,02 cm de côté. L'épaisseur du fond 402 est de 200 µm et la hauteur des parois 404 de 800 µm, par exemple.

On notera que dans le cas d'utilisation de verre ou d'un matériau isolant pour le substrat, la couche d'isolation 1108 n'est plus utile et pourra être omise.

Dans le cas de formation de piliers additionnels non conducteurs, on remplira les trous 1101 et 102, au moins sur leur pourtour, par un matériau isolant.

Tel que décrit précédemment, selon un mode de réalisation non limitatif, on obtient un assemblage comprenant un boitier étanche destiné à accueillir au moins un composant produit par l'industrie de la microélectronique pouvant optionnellement comprendre des parties optiques et/ou mécaniques. Ce boitier est réalisé de préférence à partir d'une cavité d'un matériau imperméable aux agents oxydant de son environnement, dont le fond est traversé par au moins deux piliers conducteurs isolés de la cavité ; les au moins deux piliers s'étendant dans la cavité sur une hauteur inférieure à la profondeur de la dite cavité. Dans cette configuration préférée, le dit au moins un composant comprend un nombre de passages de vias traversants au moins égal au nombre de piliers, les dits passage étant de taille appropriée et positionnés de telle façon qu'ils permettent d'enfiler le dit au moins un composant dans les piliers. Ensuite, le boitier est rempli d'une résine isolante et fermé par un capot étanche. Les au moins deux piliers établissent avantageusement chacun une connexion électrique avec le dit au moins un composant, optionnellement, après ajout d'une résine conductrice dans les passages de vias traversants préparés dans le dit composant et avant d'enfiler le dit composant dans les piliers conducteurs lors de l'assemblage.

Outre le fait que la présente invention propose une solution d'assemblage d'un unique composant électronique, elle permet aussi de réaliser des modules comprenant plusieurs composants qui peuvent être de nature électrique identique ou différente. Il est possible par exemple de réaliser un boitier étanche contenant une multitude de batteries au lithium connectées en série ou en parallèle.

## Revendications

1. Système électronique comprenant au moins un dispositif comprenant un substrat (110) portant au moins un composant électronique doté d'au moins un connecteur électrique (121, 122), le système comprenant en outre un support dudit dispositif, dans lequel le dispositif comprend au moins un passage (361, 362) suivant une dimension en épaisseur du dispositif, ledit passage traversant au moins le connecteur électrique (121, 122), le système comprenant au moins un pilier électriquement conducteur (471, 472) en saillie sur une première face du support, le pilier électriquement conducteur (471, 472) traversant le passage (361, 362) en étant configuré pour être en continuité électrique avec le connecteur électrique (121, 122) traversé par ledit passage, **caractérisé en ce qu'**il comprend un boitier (400) définissant une cavité (407) de réception du dispositif, le support formant un fond (402) du boitier (400), le boitier (400) comprenant une paroi latérale (404) s'étendant à partir du support suivant la dimension en épaisseur.

2. Système selon la revendication précédente, comprenant plusieurs dispositifs en superposition suivant la dimension en épaisseur, chacun avec un passage traversé par le au moins un pilier électriquement conducteur (471, 472).

3. Système selon l'une des revendications précédentes, dans lequel le composant électronique comprend deux connecteurs électriques (121, 122) chacun traversé par un passage (361, 362), le système comprenant deux piliers électriquement conducteurs (471, 472) chacun en continuité électrique avec un, différent, des deux connecteurs électriques (121, 122) au travers du passage (361, 362) dudit un des deux connecteurs (121, 122), et, de préférence, dans lequel le dispositif est de section rectangulaire suivant un plan perpendiculaire à la dimension en épaisseur et dans lequel les deux piliers électriquement conducteurs (471, 472) sont dirigés suivant une diagonale de ladite section.

4. Système selon l'une des revendications précédentes, dans lequel le passage traverse en outre le substrat (110) et, de préférence, dans lequel le connecteur est en appui sur le substrat (110) au moins autour du passage.

5. Système selon l'une des revendications précédentes, dans lequel le pilier électriquement conducteur (471, 472) traverse le support de sorte à être exposé au niveau d'une deuxième face du support opposée à la première face.

6. Système selon l'une des revendications précédentes, dans lequel le au moins un pilier électriquement conducteur (471, 472) comprend une interface de contact (691) configurée pour assurer une continuité électrique entre une partie de tronc du pilier et le connecteur électrique (121, 122), et de préférence, dans lequel l'interface de contact (691) est une résine ou une couche métallique électriquement conductrice, qui recouvre de préférence l'ensemble du tronc du pilier.

7. Système selon l'une des revendications précédentes, dans lequel la paroi latérale (404) et le support sont monoblocs.

8. Système selon l'une des revendications précédentes, comprenant un capot (809) fermant la cavité et prenant appui sur la paroi latérale (404).

9. Système selon la revendication précédente, dans lequel le capot (809) comprend, pour chaque pilier électriquement conducteur (471, 472), un passage suivant une dimension en épaisseur du capot de sorte à exposer le pilier électriquement conducteur (471, 472) sur une face du capot (809) orientée à l'extérieur du boitier, et de préférence, dans lequel le capot (809) porte au moins un composant électronique doté d'au moins un connecteur électrique traversé par un passage du capot (809), un des au moins un pilier électriquement conducteur (471, 472) traversant le passage en étant configuré pour être en continuité électrique avec le connecteur électrique traversé par ledit passage.

10. Système selon la revendication précédente, dans lequel au moins un composant électronique porté par le capot (809) est situé sur une face du capot (809) orientée vers l'intérieur de la cavité (407), et de préférence relié au pilier.

11. Système selon l'une des revendications précédentes, dans lequel la cavité (407) comprend un matériau de remplissage électriquement isolant autour du au moins un dispositif.

12. Système selon l'une des revendications précédentes, comprenant au moins un pilier additionnel (971, 972) en saillie sur la première face du support, chaque pilier additionnel (971, 972) traversant un passage formé dans le dispositif suivant la dimension en épaisseur, le pilier additionnel (971, 972) étant configuré pour ne pas être en continuité électrique avec un connecteur électrique (121, 122) du composant électronique.

13. Procédé de fabrication d'un système électrique comprenant au moins un dispositif comprenant un substrat portant au moins un composant électronique doté d'au moins un connecteur électrique (121, 122), le système comprenant en outre un support dudit dispositif, comprenant :
- la formation dans le dispositif d'au moins un passage (361, 362) suivant une dimension en épaisseur du dispositif, ledit passage (361, 362) traversant au moins le connecteur électrique (121, 122);
- la formation d'au moins un pilier électriquement conducteur (471, 472) en saillie sur une première face du support ;
- le montage du dispositif sur le support de sorte que chaque pilier électriquement conducteur (471, 472) traverse un passage (361, 362) en étant configuré pour être en continuité électrique avec le connecteur électrique (121, 122) traversé par ledit passage (361, 362),
**caractérisé en ce qu'**il comprend la formation d'un boitier (400) définissant une cavité (407) de réception du au moins un dispositif, le support formant un fond (402) du boitier (400), le boitier (400) comprenant une paroi latérale (404) s'étendant à partir du support suivant la dimension en épaisseur.

14. Procédé selon la revendication précédente, dans lequel la formation d'au moins un pilier électriquement conducteur (471, 472) est configurée de sorte qu'il traverse le support pour être exposé au niveau d'une deuxième face du support opposée à la première face.

15. Procédé selon la revendication précédente, dans lequel la paroi latérale (404) et le fond (402) sont obtenus par formation de la cavité (402) dans un substrat de départ, et de préférence dans lequel :
- la formation d'au moins un pilier électriquement conducteur (471, 472) comprend la formation d'un motif en creux de tronc de pilier dans le substrat de départ et le remplissage du motif par un matériau électriquement conducteur ;
- la formation du boitier (400) comprend, après la formation du au moins un pilier électriquement conducteur (471, 472), une gravure d'une portion du substrat de départ configurée pour laisser en place le au moins un pilier, le fond et la paroi latérale du boitier (400).

## Patentansprüche

1. Elektronisches System, umfassend mindestens eine Vorrichtung, umfassend ein Substrat (110), das mindestens eine mit einem elektrischen Verbindungsstück (121, 122) ausgestattete elektronische Komponente trägt, wobei das System des Weiteren einen Träger der Vorrichtung umfasst, wobei die Vorrichtung entlang einer Dickenabmessung der Vorrichtung mindestens einen Durchgang (361, 362) umfasst, wobei der Durchgang mindestens das elektrische Verbindungsstück (121, 122) durchquert, wobei das System auf einer ersten Fläche des Trägers mindestens einen hervorstehenden elektrisch leitfähigen Pfeiler (471, 472) umfasst, wobei der elektrisch leitfähige Pfeiler (471, 472) den Durchgang (361, 362) durchquert, indem er konfiguriert ist, um mit dem durch den Durchgang durchquerten elektrischen Verbindungsstück (121, 122) in elektrischer Kontinuität vorzuliegen,**dadurch gekennzeichnet, dass** es ein Gehäuse (400) umfasst, das einen Hohlraum (407) zum Aufnehmen der Vorrichtung definiert, wobei der Träger einen Boden (402) des Gehäuses (400) bildet, wobei das Gehäuse (400) eine Seitenwand (404) umfasst, die sich ausgehend von dem Träger entlang der Dickenabmessung erstreckt.

2. System nach dem vorstehenden Anspruch, umfassend mehrere entlang der Dickenabmessung überlagerte Vorrichtungen, jede mit einem Durchgang, der durch den mindestens einen elektrisch leitfähigen Pfeiler (471, 472) durchquert wird.

3. System nach einem der vorstehenden Ansprüche, wobei die elektronische Komponente zwei elektrische Verbindungsstücke (121, 122) umfasst, jede durch einen Durchgang (361, 362) durchquert, wobei das System zwei elektrisch leitfähige Pfeiler (471, 472), jeder mit von einem unterschiedlichen der zwei elektrischen Verbindungsstücke (121, 122) in elektrischer Kontinuität vorliegend, den Durchgang (361, 362) des einen der zwei Verbindungsstücke (121, 122) durchquerend, umfasst, und wobei vorzugsweise die Vorrichtung entlang einer Ebene senkrecht zu der Dickenabmessung einen rechteckigen Querschnitt aufweist, und wobei die zwei elektrische leitfähigen Pfeiler (471, 472) entlang einer Diagonalen des Querschnitts gerichtet sind.

4. System nach einem der vorstehenden Ansprüche, wobei der Durchgang des Weiteren das Substrat (110) durchquert und wobei vorzugsweise das Verbindungsstück mindestens um den Durchgang herum gegen das Substrat (110) anstößt.

5. System nach einem der vorstehenden Ansprüche, wobei der elektrisch leitfähige Pfeiler (471, 472) den Träger derart durchquert, um auf Höhe einer zweiten, der ersten Fläche gegenüberliegenden, Fläche des Trägers exponiert zu sein.

6. System nach einem der vorstehenden Ansprüche, wobei der mindestens eine elektrisch leitfähige Pfeiler (471, 472) eine Kontaktschnittstelle (691) umfasst, konfiguriert, um eine elektrische Kontinuität zwischen einem Teil des Rumpfs des Pfeiler und dem elektrischen Verbindungsstück (121, 122) zu gewährleisten, und vorzugsweise wobei die Kontaktschnittstelle (691) ein Harz oder eine elektrisch leitfähige metallische Schicht ist, die vorzugsweise die Gesamtheit des Rumpfes des Pfeilers bedeckt.

7. System nach einem der vorstehenden Ansprüche wobei die Seitenwand (404) und der Träger einstückig sind.

8. System nach einem der vorstehenden Ansprüche, umfassend eine Abdeckung (809), die den Hohlraum schließt und gegen die Seitenwand (404) anstößt.

9. System nach dem vorstehenden Anspruch, wobei die Abdeckung (809) für jeden elektrisch leitfähigen Pfeiler (471, 472) einen Durchgang entlang einer Dickenabmessung der Abdeckung derart umfasst, um den elektrisch leitfähigen Pfeiler (471, 472) auf einer an der Außenseite des Gehäuses orientierten Fläche der Abdeckung (809) zu exponieren, und vorzugsweise wobei die Abdeckung (809) mindestens eine mit mindestens einem elektrischen Verbindungsstück, das durch einen Durchgang der Abdeckung (809) durchquert wird, ausgestattete elektronische Komponente trägt, wobei einer des mindestens einen elektrisch leitfähigen Pfeilers (471, 472) den Durchgang durchquert, indem er konfiguriert ist, in elektrischer Kontinuität mit dem durch den Durchgang durchquerten elektrischen Verbindungsstück vorzuliegen.

10. System nach dem vorstehenden Anspruch, wobei mindestens eine durch die Abdeckung (809) getragene elektronische Komponente sich auf einer Fläche der Abdeckung (809) befindet, die in Richtung der Innenseite des Hohlraums (407) orientiert und vorzugsweise mit dem Pfeiler verbunden ist.

11. System nach einem der vorstehenden Ansprüche, wobei der Hohlraum (407) ein elektrisch isolierendes Füllmaterial um die mindestens eine Vorrichtung herum umfasst.

12. System nach einem der vorstehenden Ansprüche, umfassend auf der ersten Fläche des Trägers mindestens einen hervorstehenden zusätzlichen Pfeiler (971, 972), wobei jeder zusätzliche Pfeiler (971, 972) einen in der Vorrichtung entlang der Dickenabmessung gebildeten Durchgang durchquert, wobei der zusätzliche Pfeiler (971, 972) konfiguriert ist, um nicht mit einem elektrischen Verbindungsstück (121, 122) der elektronischen Komponente in elektrischer Kontinuität vorzuliegen.

13. Herstellungsverfahren eines elektrischen Systems, umfassend mindestens eine Vorrichtung, umfassend eine Substrat, das mindestens eine mit mindestens einem elektrischen Verbindungsstück (121, 122) ausgestattete elektronische Komponente trägt, wobei das System des Weiteren einen Träger der Vorrichtung umfasst, umfassend:
- die Bildung von mindestens einem Durchgang (361, 362) in der Vorrichtung entlang einer Dickenabmessung der Vorrichtung, wobei der Durchgang (361, 362) mindestens das elektrische Verbindungsstück (121, 122) durchquert;
- die Bildung von mindestens einem auf einer ersten Fläche des Trägers hervorstehenden elektrisch leitfähigen Pfeiler (471, 472);
- die Montage der Vorrichtung auf dem Träger derart, dass jeder elektrisch leitfähige Pfeiler (471, 472) einen Durchgang (361, 362) durchquert, indem er konfiguriert ist, um in elektrischer Kontinuität mit dem durch den Durchgang (361, 362) durchquerten elektrischen Verbindungsstück (121, 122) vorzuliegen, **dadurch gekennzeichnet, dass** sie die Bildung eines Gehäuses (400) umfasst, das einen Hohlraum (407) zur Aufnahme der mindestens einen Vorrichtung definiert, wobei der Träger einen Boden (402) des Gehäuses (400) bildet, wobei das Gehäuse (400) eine Seitenwand (404) umfasst, die sich ausgehend von dem Träger entlang einer Dickenabmessung erstreckt.

14. Verfahren nach dem vorstehenden Anspruch, wobei die Bildung von mindestens einem elektrisch leitfähigen Pfeiler (471, 472) derart konfiguriert ist, dass er den Träger durchquert, um auf Höhe einer zweiten, der ersten Fläche gegenüberliegenden, Fläche des Trägers exponiert zu sein.

15. Verfahren nach dem vorstehenden Anspruch, wobei die Seitenwand (404) und der Boden (402) durch Bildung des Hohlraums (402) in einem Ausgangssubstrat erhalten werden, und wobei vorzugsweise:
- die Bildung von mindestens einem elektrisch leitfähigen Pfeiler (471, 472) die Bildung eines Vertiefungsmusters des Rumpfes des Pfeilers in dem Ausgangssubstrat und das Füllen des Musters durch ein elektrisch leitfähiges Material umfasst;
- die Bildung des Gehäuses (400) nach der Bildung des mindestens einen elektrisch leitfähigen Pfeilers (471, 472) eine Gravur eines Abschnitts des Ausgangssubstrat umfasst, konfiguriert, um den mindestens einen Pfeiler, den Boden und die Seitenwand des Gehäuses (400) an Ort und Stelle zu lassen.

## Claims

1. Electronic system comprising at least one device comprising a substrate (110) carrying at least one electronic component equipped with at least one electrical connector (121, 122), the system further comprising a support of said device, wherein the device comprises at least one passage (361, 362) according to a dimension in thickness of the device, said passage passing through at least the electrical connector (121, 122), the system comprising at least one electrically conductive pillar (471, 472) protruding over a first face of the support, the electrically conductive pillar (471, 472) passing through the passage (361, 362) by being configured to be in electrical continuity with the electrical connector (121, 122) passed through by said passage, **characterised in that** it comprises a casing (400) defining a cavity (407) for receiving the device, the support forming a bottom (402) of the casing (400), the casing (400) comprising a side wall (404) extending from the support according to the dimension in thickness.

2. System according to the preceding claim, comprising several superimposed devices according to the dimension in thickness, each with a passage passed through by the at least one electrically conductive pillar (471, 472).

3. System according to one of the preceding claims, wherein the electronic component comprises two electrical connectors (121, 122), each passed through by a passage (361, 362), the system comprising two electrically conductive pillars (471, 472), each in electrical continuity with one, different, of the two electrical connectors (121, 122) through the passage (361, 362) of said one of the two connectors (121, 122), and, preferably, wherein the device is of a rectangular section along a plane perpendicular to the dimension in thickness and wherein the two electrically conductive pillars (471, 472) are directed along a diagonal of said section.

4. System according to one of the preceding claims, wherein the passage furthermore passes through the substrate (110) and, preferably, wherein the connector is born against the substrate (110) at least around the passage.

5. System according to one of the preceding claims, wherein the electrically conductive pillar (471, 472) passes through the support so as to be exposed at the level of a second face of the support opposite the first face.

6. System according to one of the preceding claims, wherein the at least one electrically conductive pillar (471, 472) comprises a contact interface (691) configured to ensure an electrical continuity between a stem portion of the pillar and the electrical connector (121, 122), and preferably, wherein the contact interface (691) is a resin or an electrically conductive metal layer, which preferably covers all of the stem of the pillar.

7. System according to one of the preceding claims, wherein the side wall (404) and the support are made of one piece.

8. System according to one of the preceding claims, comprising a cap (809) closing the cavity and bearing against the side wall (404).

9. System according to the preceding claim, wherein the cap (809) comprises, for each electrically conductive pillar (471, 472), a passage according to a dimension in thickness of the cap, so as to expose the electrically conductive pillar (471, 472) on a face of the cap (809) oriented outside of the casing, and preferably, wherein the cap (809) carries at least one electronic component equipped with at least one electrical connector passed through by a passage of the cap (809), one of the at least one electrically conductive pillar (471, 472) passing through the passage by being configured to be in electrical continuity with the electrical connector passed through by said passage.

10. System according to the preceding claim, wherein at least one electronic component carried by the cap (809) is located on a face of the cap (809) oriented towards the inside of the cavity (407), and preferably connected to the pillar.

11. System according to one of the preceding claims, wherein the cavity (407) comprises an electrically insulating filler material around the at least one device.

12. System according to one of the preceding claims, comprising at least one additional pillar (971, 972) protruding over the first face of the support, each additional pillar (971, 972) passing through a passage formed in the device according to the dimension in thickness, the additional pillar (971, 972) being configured to not be in electrical continuity with an electrical connector (121, 122) of the electronic component.

13. Method for producing an electrical system comprising at least one device comprising a substrate carrying at least one electronic component equipped with at least one electrical connector (121, 122), the system further comprising a support of said device, comprising:
- the formation, in the device, of at least one passage (361, 362) according to a dimension in thickness of the device, said passage (361, 362) passing through at least the electrical connector (121, 122);
- the formation of at least one electrically conductive pillar (471, 472) protruding over a first face of the support;
- the mounting of the device on the support, such that each electrically conductive pillar (471, 472) passes through a passage (361, 362) by being configured to be in electrical continuity with the electrical connector (121, 122) passed through by said passage (361, 362),
**characterised in that** it comprises the formation of a casing (400) defining a cavity (407) for receiving the at least one device, the support forming a bottom (402) of the casing (400), the casing (400) comprising a side wall (404) extending from the support according to the dimension in thickness.

14. Method according to the preceding claim, wherein the formation of at least one electrically conductive pillar (471, 472) is configured such that it passes through the support to be exposed at the level of a second face of the support opposite the first face.

15. Method according to the preceding claim, wherein the side wall (404) and the bottom (402) are obtained by formation of the cavity (402) in a starting substrate, and preferably wherein:
- the formation of at least one electrically conductive pillar (471, 472) comprises the formation of a pattern in the pillar stem cavity in the starting substrate and the filling of the pattern with an electrically conductive material;
- the formation of the casing (400) comprises, after the formation of the at least one electrically conductive pillar (471, 472), an etching of a portion of the starting substrate configured to leave in place, the at least one pillar, the bottom and the side wall of the casing (400).
